Europäisches Patentamt

European Patent Office

Office européen des brevets

(11) Publication number: 0 219 241
A2

# EUROPEAN PATENT APPLICATION

(21) Application number: 86307290.6

(22) Date of filing: 23.09.86

(51) Int. Cl.4: H01L 29/60 , H01L 29/78 , //G11C17/00

(30) Priority: 16.10.85 JP 230184/85

(43) Date of publication of application:
22.04.87 Bulletin 87/17

(84) Designated Contracting States:
DE GB

(71) Applicant: SEIKO INSTRUMENTS &
ELECTRONICS LTD.
31-1, Kameido 6-chome
Koto-ku Tokyo 136(JP)

(72) Inventor: Kamiya, Masaaki c/o Seiko Instr. &
Electronics Ltd
31-1, Kameido 6-chome Koto-ku
Tokyo(JP)
Inventor: Imura, Yukihiro c/o Seiko Instr. &
Electronics Ltd
31-1, Kameido 6-chome Koto-ku
Tokyo(JP)
Inventor: Takahashi, Katsuyuki Seiko Instr.
Electronics, Ltd. 31-1, Kameido 6-chome
Koto-ku Tokyo(JP)

(74) Representative: Caro, William Egerton et al
J. MILLER & CO. Lincoln House 296-302 High
Holborn
London WC1V 7JH(GB)

(54) Non-volatile semiconductor memory.

(57) A non-volatile semiconductor memory comprises source and drain regions (2,3) provided on a semiconductor substrate (1) of one conductivity type opposite to that of the source and drain regions, a gate insulator film (4) provided on the surface of a portion of the substrate which is located between the source and drain regions, a floating gate electrode (6) provided on part of the gate insulator film, and a tunnel insulator film abuts against the other part of the floating gate electrode and constitutes a CVD insulator film (5). An electrode, for example the drain region 3, transfers electric charge between the same and the floating gate electrode, provided opposite to the floating gate electrode through the tunnel insulator film. A control gate (8) is provided above the floating gate electrode through an insulator film.

FIG.1

5 CVD INSULATOR FILM

## NON-VOLATILE SEMICONDUCTOR MEMORY

This invention relates to non-volatile semiconductor memories.

A floating gate type· erasable and programmable non-volatile semiconductor memory - (EEPROM) is disclosed in U.S. Patent Specification No. 4,203,158.

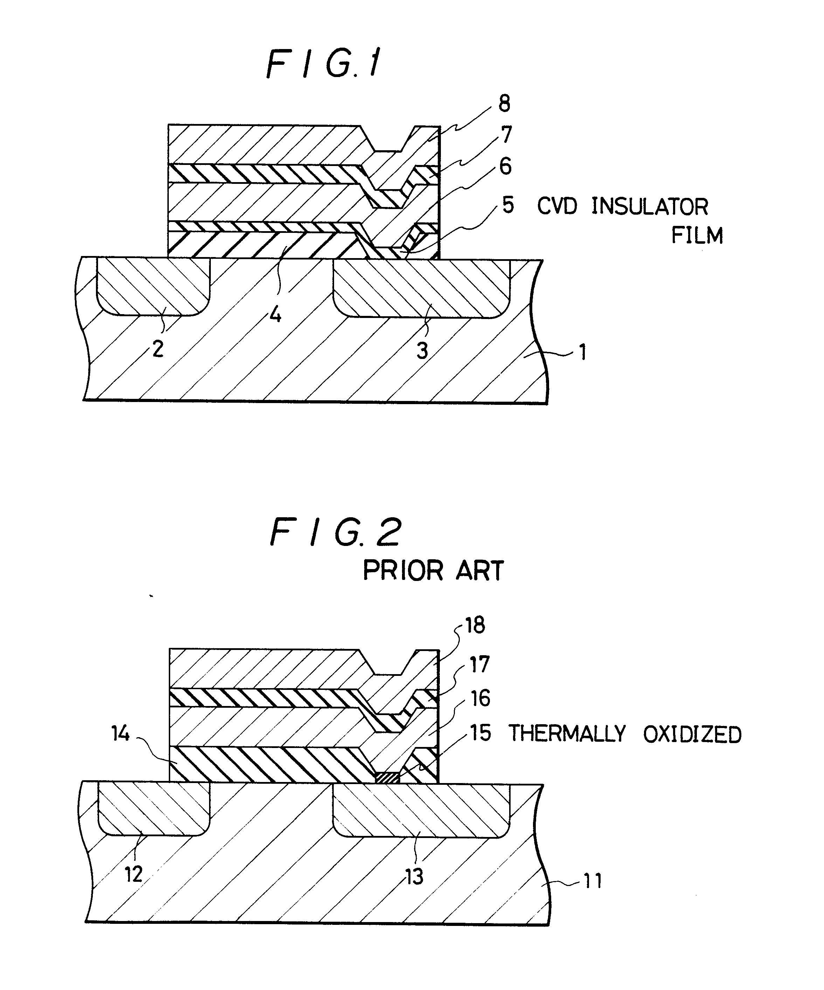

Figure 2 is a sectional view of a conventional floating gate type EEPROM. On the surface of a P-type semiconductor substrate 11, there are provided an N$^+$-type source region 12 and a drain region 13, above which is provided a gate.oxidised film 14. In a small area adjacent to the drain region 13, there is provided a thin oxidised film 15, above which is provided a floating gate electrode 16, a second gate oxidised film 17 and a control gate electrode 18.

A writing operation is conducted by applying a writing voltage to the control gate electrode 18, so that electrons are injected from thedrain region 13 into the floating gate electrode 16 through the thin oxidised film 15. An erasing operation is conducted by applying an erasing voltage to the control gate electrode 18, so that electrons are emitted from the floating gate electrode 16 into the drain region 13 through the thin oxidised film 15.

Writing and erasing operations of this floating gate type EEPROM are effected by means of a Fowler-Nordheim tunnel current through a thin oxidised film (100 to 150Å). This thin oxide film for writing and erasing operations has heretofore been constituted by a thermally oxidised film. The thermally oxidised film 15 conventionally employed for writing and erasing has, however, the disadvantage that breakdown occurs after about $10^4$ writing and erasing operations.

To solve this problem, the present invention employs a CVD insulator film for writing and erasing operations in place of a thermally oxidised film. It has heretofore been considered that a CVD insulator film is inferior to a thermally oxidised film in terms of characteristics, e.g., lower density and large leakage current. However, it has been found that a CVD oxide film which is formed at a high temperature, i.e., 700°C or higher, has superior characteristics to those of a thermally oxidised film.

More specifically, such a CVD insulator film exhibits excellent characteristics when used as a thin film region of the order of 100Å , that is, the CVD insulator film has a large breakdown current density and is not readily broken down in contrast to the thermally oxidised film. Thus, the present invention employs a CVD insulator film as a tunnel insulator film.

Employment of a CVD insulator film for writing and erasing in a floating gate type EEPROM as described above enables the EEPROM to be capable of an increased number of writing and erasing operations, e.g. about $10^5$, which is more than 100 times greater than in the case of the prior art.

According to the present invention there is provided a non-volatile semiconductor memory comprising: source and drain regions respectively provided on a semiconductor substrate of one conductivity type opposite to that of the source and drain regions; a gate insulator film provided on the surface of a portion of said substrate which is located between said source and drain regions; a floating gate electrode provided on part of said gate insulator film; and a tunnel insulator film abuted against the other part of said floating gate electrode and constituting a CVD insulator film, characterised by an electrode for transferring electric charge between the same and said floating gate electrode, provided opposite to said floating gate electrode through said tunnel insulator film; and a control gate electrode provided above said floating gate electrode through an insulator film.

Preferably said CVD insulator film is consituted by a CVD silicon oxide film formed at a temperature less than 700°C.

In one embodiment said drain region also serves as said electrode which transfers electric charge between the same and said floating gate electrode.

The invention is illustrated, merely by way of example, in the accompanying drawings, in which:-

Figure 1 is a sectional view of one embodiment of a non-volatile semiconductor memory according to the present invention;

Figure 2 is a sectional view of a conventional floating gate type EEPROM,

Figure 3 is a sectional view of a second embodiment of a non-volatile semiconductor memory according to the present invention;

Figure 4 shows rewriting characteristics of a non-volatile semiconductor memory according to the present invention which employs a CVD insulator film and a conventional EEPROM which employs a thermally oxidised film, respectively; and

Figure 5 shows the respective breakdown current densities of a CVD insulator film and a thermally oxidised film.

Referring first to Figure 1 there is shown a non-volatile semiconductor memory or floating gate type EEPROM according to the present invention. On the surface of a P-type semiconductor substrate, N$^+$-type source and drain regions 2,3 are formed, and a gate oxide film 4 is provided thereon. A CVD insulator film 5 of 100Å thickness is provided on a small region in the vicinity of the drain region, and a floating gate electrode 6, a second gate oxide film 7 and a control gate electrode 8 are provided in that order on the CVD insulator film 5.

A writing operation is conducted by applying a writing voltage to the control gate electrode 8, so that electrons are injected from the drain region 3 into the floating gate electrode 6 through the CVD insulating film 5.

An erasing operation is conducted by applying an erasing voltage to the control gate electrode 8, so that electrons are emitted from the floating gate electrode 6 into the drain region 3 through the CVD insulator film 5.

The CVD insulator film 5 is formed using dichlorosilane ($SiH_2Cl_2$) and nitrousoxide ($N_2O$) and a film is formed under a vacuum and at a temperature of 700 to 900°C. This CVD insulator film 5 exhibits excellent characteristics when of a thickness of the order of 100Å. That is, it has a large breakdown current density and is not readily broken down in contrast to the thermally oxidised film 15 of the conventional floating gate type EEPROM. It is therefore possible greatly to increase the number of possible writing and erasing operations.

It should be noted that, although a CVD oxide film is employed as the CVD insulator film 5, the chemical vapour deposition process is not the only one that can be used.

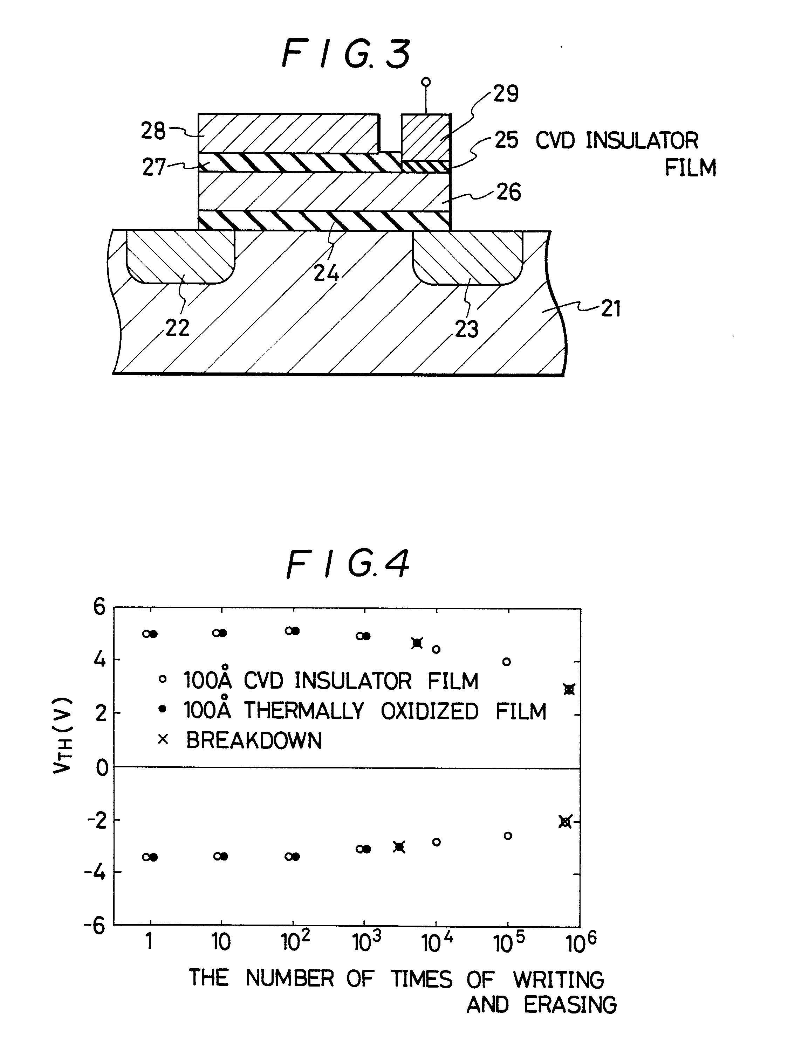

Figure 4 shows the respective rewriting characteristics of the floating gate type EEPROM of Figure 1 which employs the CVD insulator film 5 and the conventional EEPROM of Figure 2 which employs a thermally oxidised film. In the graph shown in Figure 4, the number of possible writing and erasing operations is plotted along the abscissa and the threshold value ($V_{TH}$) is plotted along the ordinate. It will be understood from Figure 4 that the EEPROM of Figure 1 which employs the CVD insulator film 5 is relatively durable and breaks down after about $10^6$ writing and erasing operations, whereas the conventional EEPROM, which employs the thermally oxidised film 15 breaks down after about $10^4$ writing and erasing operations. The EEPROM of Figure 1 has less change in the threshold value and therefore exhibits high reliability.

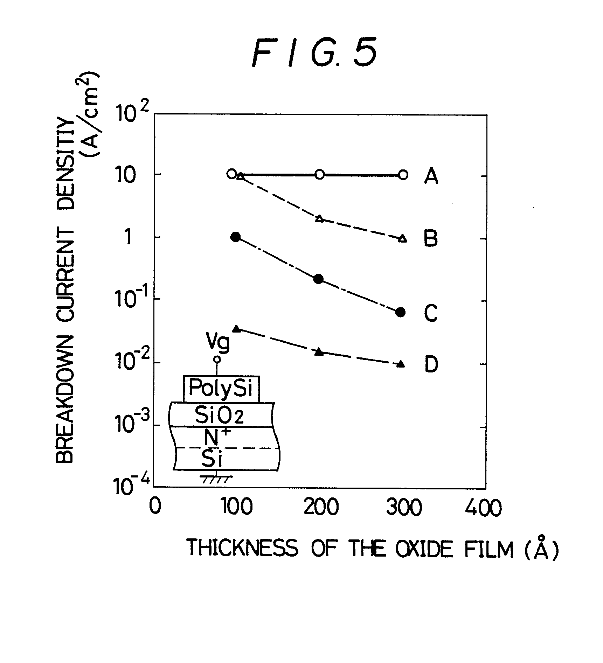

The reason for this will be explained below. Figure 5 shows the respective breakdown current densities of the CVD insulator film 5 and the thermally oxidised film 15. In the graph shown in Figure 5, the thickness of the oxide film is plotted along the abscissa and a breakdown current density is plotted along the ordinate. In Figure 5, the marks shown are as follows:

O ..... breakdown current (A) of the CVD insulator film 5 when the gate voltage $V_g$ is positive;

Δ ..... breakdown current (B) of the CVD insulator film 5 when the gate voltage $V_g$ is negative;

● ..... breakdown current (C) of the thermally oxidised film 15 when the gate voltage $V_g$ is positive;

▲ ..... breakdown current (D) of the thermally oxidised film 15 when the gate voltage $V_g$ is negative.

It will be understood from Figure 5 that the CVD insulator film 5 exhibits a larger breakdown current density than that of the thermally oxidised film 15. Accordingly, the CVD insulator film 5 enables the number of writing and erasing operations to be increased by a large margin in contrast to the thermally oxidised film 15.

Figure 3 is a sectional view of a non-volatile semiconductor memory or floating gate type EEPROM according to a second embodiment of the present invention.

On the surface of a P-type semiconductor substrate 21, $N^+$-type source and drain regions 22,23 are formed, and a gate oxide film 24 and a floating gate electrode 26 are provided thereon. In addition, a second gate oxide film 27 and a control gate electrode 28 are provided on the left-hand portion of the floating gate electrode 26, while a CVD insulator film 25 of 100Å thickness and a writing and erasing electrode 29 are provided on the right-hand portion of the floating gate electrode 26, the electrode 29 being adapted to transfer electric charge between the same and the floating gate electrode 26.

A writing operation is conducted by applying a writing voltage to the control gate electrode 28 opposite to that of the electrode 29, so that electrons are injected from the electrode 29 into the floating gate electrode 26 through the CVD insulator film 25. An erasing operation is conducted by applying an erasing voltage to the control gate electrode 28, so that electrons are emitted from the floating gate electrode 26 into the electrode 29 through the CVD insulator film 25.

In this embodiment, the floating gate electrode 26 below the CVD insulator film 25 may be formed of polycrystalline silicon. Similar to the embodiment of Figure 1, the CVD insulator film 25 also enables the possible number of writing and erasing operations to be increased by a large margin as compared with the conventional EEPROM of Figure 2 which employs a thermally oxidised film.

The non-volatile semiconductor memory according to the present invention and described above employs a CVD insulator film 5 as a tunnel oxide film and thereby offers the advantage that the number of possible writing and erasing operations can be increased to about 100 times that of conventional floating gate EEPROMs which employ a thermally oxidised film. Accordingly, the present invention can provide a highly reliable floating gate type EEPROM.

## Claims

1. A non-volatile semiconductor memory comprising: source and drain regions (2,3; 22,23) respectively provided on a semiconductor substrate - (1; 21) of one conductivity type opposite to that of the source and drain regions; a gate insulator film - (4; 24) provided on the surface of a portion of said substrate which is located between said source and drain regions; a floating gate electrode (6; 26) provided on part of said gate insulator film; and a tunnel insulator film abuted against the other part of said floating gate electrode and constituting a CVD insulator film (5; 25), characterised by an electrode (3; 29) for transferring electric charge between the same and said floating gate electrode (6; 26), provided opposite to said floating gate electrode through said tunnel insulator film, and a control gate electrode (8; 28) provided above said floating gate electrode through an insulator film.

2. A non-volatile semiconductor memory as claimed in claim 1 characterised in that said CVD insulator film is constituted by a CVD silicon oxide film formed at a temperature less than 700°C.

3. A non-volatile semiconductor memory as claimed in claim 1 or 2 characterised in that said drain region (3) also serves as said electrode which transfers electric charge between the same and said floating gate electrode (6).

# F I G. 1

8
7
6
5  CVD INSULATOR
       FILM
4
2      3      1

# F I G. 2

PRIOR ART

18
17
16
15  THERMALLY OXIDIZED
14
12      13      11

# F I G. 3

28, 27, 29, 25 CVD INSULATOR FILM, 26, 24, 22, 23, 21

# F I G. 4

○ 100Å CVD INSULATOR FILM
● 100Å THERMALLY OXIDIZED FILM
✕ BREAKDOWN

$V_{TH}(V)$

THE NUMBER OF TIMES OF WRITING AND ERASING

# F I G. 5